Europäisches Patentamt

European Patent Office

Office européen des brevets

(19)

(11) Publication number: **0 044 713**
**B1**

(12) EUROPEAN PATENT SPECIFICATION

(45) Date of publication of patent specification: **03.04.85**

(51) Int. Cl.⁴: **G 11 B 5/09**

(21) Application number: **81303275.2**

(22) Date of filing: **16.07.81**

(54) Circuit arrangements for processing digital data.

(30) Priority: **17.07.80 JP 97777/80**

(43) Date of publication of application:
**27.01.82 Bulletin 82/C4**

(45) Publication of the grant of the patent:
**03.04.85 Bulletin 85/14**

(84) Designated Contracting States:
**DE FR GB IT NL**

(56) References cited:
**US-A-4 211 997**

**RADIO MENTOR ELECTRONIC, vol. 39 no. 1,
January 1973. "PCM für bessere Schalplatten"
page 030-031
JOURNAL OF AUDIO ENGINEERING SOCIETY,
vol. 28, no. 4, April 1980, New York, US
"Consumer use PCM-encoder-decoder"
(Technical Committee reports) pages 260-269**

(73) Proprietor: **SONY CORPORATION
7-35 Kitashinagawa 6-Chome Shinagawa-ku
Tokyo 141 (JP)**
(73) Proprietor: **Kabushiki Kaisha Toshiba
72, Horikawa-cho Saiwai-ku
Kawasaki-shi Kanagawa-ken 210 (JP)**

(72) Inventor: **Hoshimi, Susumu
23 Nakao-cho Asahi-ku
Yokohama-shi Kanagawa-ken (JP)**
Inventor: **Kojima, Tadashi
20-49 Kugo-cho 6-chome
Yokosuka-shi Kanagawa-ken (JP)**

(74) Representative: **Thomas, Christopher Hugo
et al
D Young & Co 10 Staple Inn
London WC1V 7RD (GB)**

Courier Press, Leamington Spa, England.

## Description

This invention relates to circuit arrangements for processing digital data obtained by the conversion of information signals, such as audio signals, to digital data, for example to pulse code modulated (PCM) signals. Control data are used, for example, for the discrimination of the type of signal data and control thereof.

When recording and reproducing audio signals such as musical signals in the form of a PCM signal with the usual home video tape recorder (VTR), it is necessary to convert the PCM signal into a signal of a data format conforming to a television signal of a standard system such as the NTSC or the PAL system.

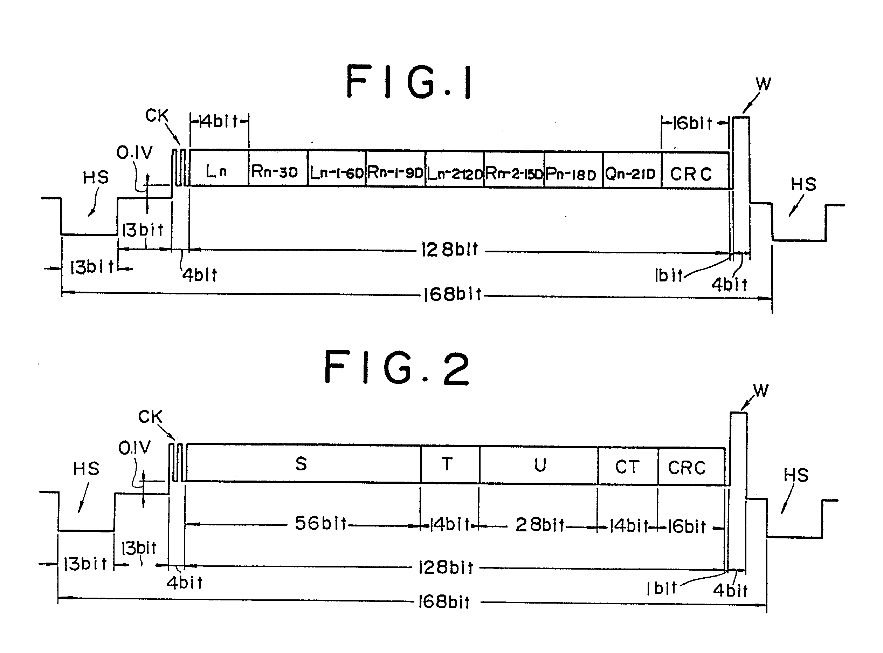

As an example of the conversion into a PCM signal, 2-channel stereophonic audio signals are individually sampled at a sampling frequency of about 44 kHz, and one sample data (that is, one word) is converted into a 16 or 14-bit PCM digital data, which is placed in a video signal portion of a standard television signal. Figure 1 of the accompanying drawings shows an example of the data format of one horizontal scanning period (1 H period) in the case when one word is the 14-bit data mentioned above. In the data block for 1 H shown in Figure 1, six words of PCM signals for the left and right channels arranged alternately, two error correction words P and Q, and one 16-bit error detection word CRC (cyclic redundancy check) constitute a 9-word 128-bit data block. The PCM data L and R shown in Figure 1 respectively correspond to the left and right sampled data, and the suffixes attached represent the sampling order. In the format of Figure 1, an interleave is used such that in each sampled data the six words and two error correction words P and Q, that is, a total of eight words, are successively shifted by sixteen blocks, that is, sixteen horizontal lines for each word, and D in the aforementioned suffixes represents this number of blocks (D=16) of the interleave. In this case, the interleave of D=16 blocks is equivalent to a word interleave of 3 D=48 words.

Moreover, in Figure 1, the period of one horizontal line (1 H) is 168 bits. In this 168-bit interval, the horizontal sync signal HS which is of 13 bits is placed first, then a 4-bit clock signal CK for synchronization of data is placed after an interval of 13 bits, and then the aforementioned 128-bit data block is placed. The code of the data synchronization signal CK is, for example, "1010". Also, after the 128-bit data block a "0" signal of one bit is placed, and then a white reference signal W with a pulse width of 4 bits is placed.

Figure 2 of the accompanying drawings shows a 1 H period in which a control signal data block CDB is contained. This format is the same as that of Figure 1 except for the 128-bit control data block, including the horizontal sync signal HS and white reference signal W. The 128-bit control data block here is constituted by a 56-bit heading signal word S, a 14-bit content discrimination signal word T, a 28-bit address signal word U, a 14-bit control signal word CT, and the aforementioned 16-bit error detection word CRC.

The content of the 14-bit control signal word CT is set such as shown in Table 1.

TABLE 1

| Bit No. | Code content | Control content | Bit content |
|---|---|---|---|
| 1 to 10 | No prescription | — | 0 |
| 11 | Dubbing inhibition code | Absent | 0 |
| 12 | P correction discrimination code | Present | 0 |
| 13 | Q correction discrimination code | Present | 0 |
| 14 | Pre-emphasis discrimination code | Present | 0 |

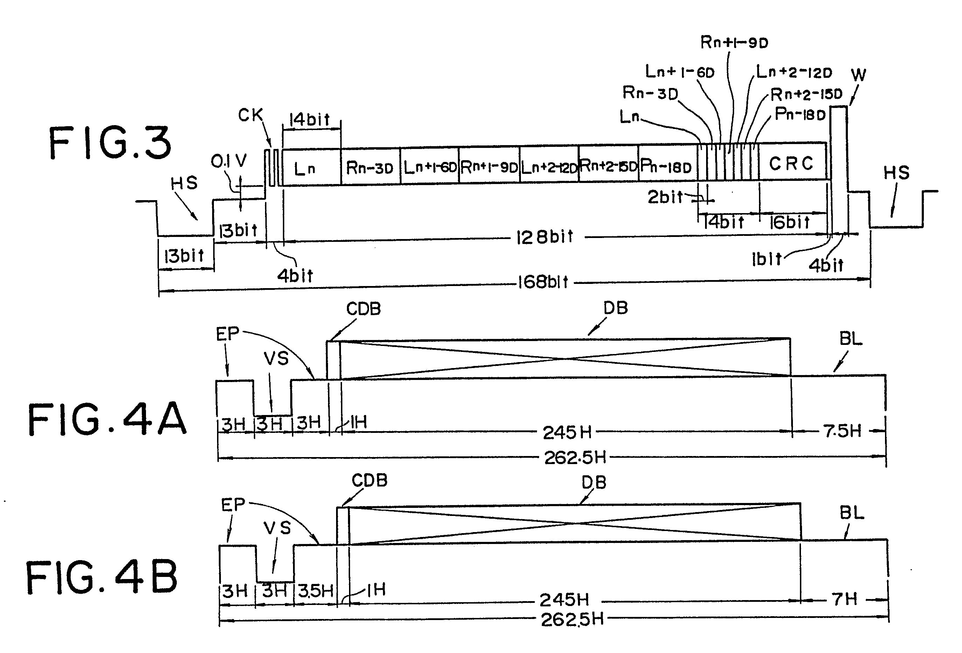

In Table 1, the Q correction discrimination code is "0" representing "presence" in the case where one word of the PCM audio signal is constituted by 14 bits, while where one word is constituted by 16 bits, for instance as in the data format shown in Figure 3 of the accompanying drawings, the Q correction discrimination code is "1" representing "absence".

Figure 3 shows an example of the data block in which one word of the PCM audio signal mentioned above is constituted by 16-bits, that is, the 128-bit data block is constituted by six 16-bit words of the left and right channel audio signal data L and R, a 16-bit error correction word P and a 16-bit error detection word CRC, that is, a total of eight words.

The above data signals for 1 H unit are arranged in one vertical scanning period, (that is, one field) in a manner as shown, for example, in Figures 4A and 4B of the accompanying drawings. Figure 4A corresponds to an odd field, and Figure 4B corresponds to an even field. At the beginning of each field, the equivalent pulse EP and vertical sync signal VS are arranged, the control data block CDB is provided in the 10th horizontal line in the odd field (see Figure 4A) and the 10.5th horizontal line in the even field (see Figure 4B), and then 245 horizontal lines with data blocks DB are provided, the remaining horizontal lines constituting a blank period BL.

Of the 262.5 horizontal lines constituting one field in Figures 4A and 4B, the 16.6 lines other than the 246 lines in which the aforementioned control data block CDB and data block DB are provided correspond to the vertical blanking period of the standard television signal.

When recording and reproducing the PCM audio signal of a format as described above, using the usual home VTR, or a conventional PCM processor as referred to, for example, in "Radio Mentor Electronic", Vol 39, no. 1, January 1973, pages 030 to 031, or "Journal of Audio Engineering Society", Vol 28, no 4, April 1980, pages 260 to 269, both mentioned in the European search report, complex techniques of digital signal processing are required in the playback.

Due to the recent advances of semiconductor techniques it is possible to construct the main part of the circuitry as a high density integrated circuit, that is, by using only several large scale integrated (LSI) elements. In such an LSI element, however, the package size is the main factor determining the price of the element, that is, the price increases with an increasing number of pins. The present invention is concerned with avoiding the need to increase the number of pins.

According to the present invention there is provided a circuit arrangement for processing digital data in serial format, the arrangement comprising:

an integrated circuit with a clock terminal, a read-write terminal, an input terminal for receiving said digital data, an output terminal for deriving blocks of digital data each preceded by a synchronizing signal, data terminals and address terminals; and

memory means connected to said read-write terminal, data terminals and address terminals of said integrated circuit; characterised by:

at least one control data input terminal for receiving control data to be transmitted together with said digital data or control data to control functions of said integrated circuit; and

a buffer circuit connected between said at least one control data input terminal and one or more of said data terminals of said integrated circuit;

wherein said integrated circuit further includes at least one control terminal and provides said buffer circuit through said control terminal with a control signal so as to make said buffer circuit conductive at times corresponding to said synchronizing signal when said control data from said at least one control data input terminal is to be supplied to said integrated circuit.

Embodiments of the invention can reduce or at least prevent increase in the number of pins of the LSI element used and permit provision of an inexpensive arrangement by permitting the transmission of data to and from the LSI element to be effected by additionally using the data bus used for transmitting actual signal data obtained through digitalization of the aforementioned audio signal as the input/output lines for the control signal data.

The form and timing of the control data need not be altered, because the control data is supplied to the data bus during the sync signal period of the digital signal or a period during which the actual signal data is not present.

It is also possible to avoid influence upon the input and output of the actual signal data by connecting a tri-state buffer circuit, which can take, in addition, to "H" and "L" signal level states, a further state, that is, a floating state, to the data bus, such that the control data is transmitted through this tri-state buffer circuit and the tri-state buffer circuit is held in the floating state during periods other than when the control data is transmitted.

The invention will now be further described by way of example with reference to the accompanying drawings, in which:

Figures 1 to 4A and 4B are time charts showing examples of the data format for the recording and reproduction of PCM audio signals;

Figure 5 is a block circuit diagram showing an embodiment of the invention;

Figures 6A, 6B and 6C and Figures 7A, 7B and 7C are time charts illustrating the timing of the appearance of pulses from chip select terminals $CS_2$ and $CS_3$ in Figure 5; and

Figure 8 is a block circuit diagram showing a specific circuit construction in the region of a playback LSI 40 in Figure 5.

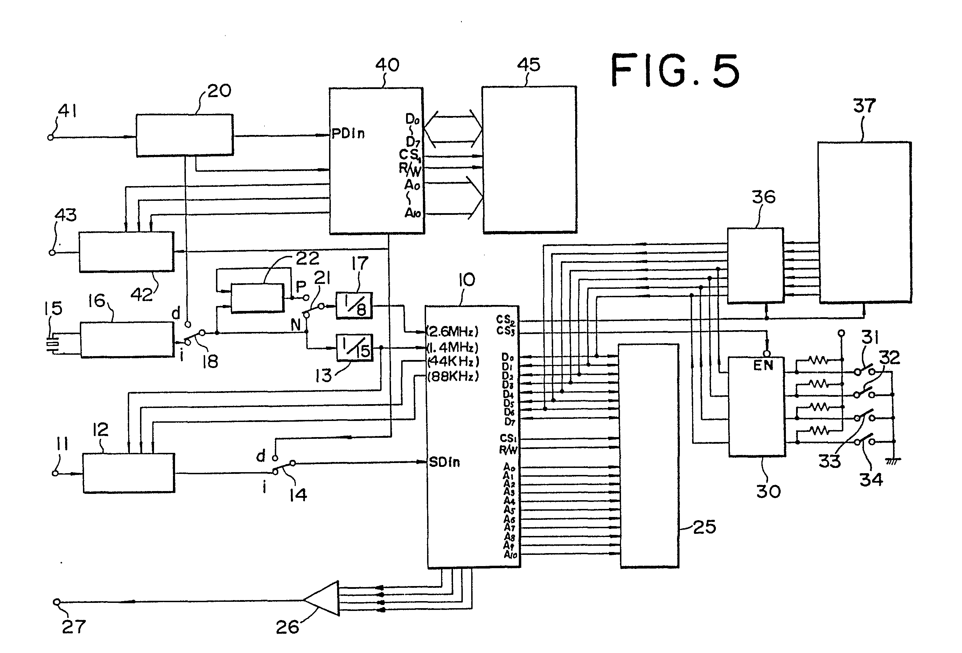

Figure 5 is a block circuit diagram showing the whole of the embodiment to be described, and in which control data as mentioned above is supplied to some of eight pins $D_0$ to $D_7$ of a PCM signal recording LSI element 10, hereinafter referred to the recording LSI 10, namely to the four pins $D_0$ to $D_3$.

An analog audio signal is supplied through an analog input terminal 11 to an analog-to-digital (A/D) converter 12, and is converted there into a PCM digital audio signal. The A/D converter 12 samples, for example, 2-channel audio signals respectively corresponding to left and right stereo channels alternately, that is, at different timings at a sampling frequency of about 44 kHz, and converts each sampled data (that is, one word) into a 16-bit digital code data. The clock frequency of the data is thus about 1.4 MHz (that is, 1.4 Mbits/sec), and this 1.4 MHz bit clock signal is supplied from a frequency divider 13. To the A/D converter 12 are also supplied a word clock signal (of about 44 kHz) for the aforementioned sampling and a double frequency word clock signal (at about 88 kHz) from the recording LSI 10. The PCM audio signal containing words each of 16 bits, provided from the A/D converter 12, is supplied through a switch 14 to a serial data input terminal $SD_{in}$ of the LSI 10. The switch 14, which engages its terminal $d$ at the time of dubbing signals, normally engages its terminal $i$ to couple the output of the A/D converter 12 to the LSI 10.

The supply of a clock signal to the LSI 10 is done by frequency dividing a signal, for instance at about 21 MHz, from an oscillator 16 to which a crystal oscillator element 15 is connected through a frequency divider 13 or 17. A switch 18, which is connected to the output of the oscillator 16, engages its terminal $d$ to receive a signal from a sync separation circuit 20 at the time of dubbing, but normally engages its terminal $i$ to couple the signal from the oscillator 16 to the frequency divider 13. The frequency divider 13 divides the frequency of the signal at about 21 MHz from the oscillator 16 by fifteen, thus providing a bit block signal of about 1.4 MHz, which is supplied to the A/D converter 12 and the recording LSI 10. The frequency divider 17 is a 1/8 frequency divider, and supplies a bit clock signal of about 2.6 MHz to the recording LSI 10. A switch 21, which is connected to the input side of the frequency divider 17, engages its terminal N when the standard television signal dealt with is of the NTSC system, while it engages its terminal P in the case of the PAL system. In the case of the PAL system, the output of the oscillator 16 is frequency converted by a frequency converter 22, which includes a phase locked loop circuit and other circuits, and supplied through the terminal P of the switch 21 to the 1/8 frequency divider 17. The oscillator 16 is also adapted to provide slightly different frequencies for the NTSC and PAL systems.

The recording LSI 10 has eleven address terminals $A_0$ to $A_{10}$, eight data terminals $D_0$ to $D_7$, three chip select terminals $CS_1$ to $CS_3$, and a read/write terminal R/W. The address terminals $A_0$ to $A_{10}$ and the data terminals $D_0$ to $D_7$ are all connected through respective address bus lines and data bus lines to corresponding terminals of a random access memory (RAM) 25 which is capable of writing and reading data in and out of it. The RAM 25 may, for example, be a static RAM to 16 Kbits (8 bits×2048), and it is selected by the output from the chip select terminal $CS_1$ of the recording LSI 10 for writing or reading according to the output from the read/write terminal R/W.

To the serial data input terminal $SD_{in}$ of the recording LSI 10, is supplied serial data of about 1.4 Mbits/sec consisting solely of actual signal data with each word of 16 bits, and the recording LSI 10 supplies every 8 bits of this serial data as 8-bit parallel data to the RAM 25 for writing therein. The write pulse signal at this time is of about 2.8 microseconds, and the reading of data from the RAM 25 is made with a timing not overlapping the write pulses (that is, between adjacent write pulses). At this time, the recording LSI 10 effects reading of data according to the aforementioned word interleave, processes the error correction words P and Q and error detection word CRC, and also adds the sync signal, that is, it effects conversion of data into the data format conforming to the standard television signal as shown in Figure 4A or 4B to provide serial data at about 2.6 Mbits/sec.

From the recording LSI 10, the data block DB or control data block CDB, white reference signal W, level shift portion between adjacent data sections (the shift being made by, for instance, about 0.1 V), sync signal HS, etc., as the components of the format shown in Figures 1 or 2, are respectively derived from independent output terminals $RD_{out}$ and are added together in an adder amplifier 26 to form the aforementioned serial data signal at about 2.6 Mbits/sec which is supplied to an output terminal 27.

At least one data bus connected to the data terminals $D_0$ to $D_7$ which form an input/output port of the recording LSI 10, namely four data lines corresponding to the terminals $D_0$ to $D_3$, are respectively connected to four output terminals of a tri-state (or three state) buffer circuit 30, and switches 31 to 34 are respectively connected to four input terminals of this tri-state buffer circuit 30. The switches 31 to 34 control data input switches, and they correspond to, for example, the emphasis discrimination data, Q correction word discrimination data, NTSC/PAL discrimination data and dubbing inhibition discrimination data respectively. When these switches 31 to 34 are all "off", the four outputs of the tri-state buffer circuit 30 are all at "H" level, that is, they represent the "presence" of emphasis, "presence" of Q correction word, selection of the NTSC system, and "absence" of dubbing inhibition respectively. Of these four control data, the three concerning the emphasis, Q correction and dubbing inhibition respectively, are placed in predetermined bit positions of the control signal word CT of the control data block CDB mentioned above, and their bit contents are all "0". When one of the switches 31 to 34 is turned "on", the corresponding output of the tri-state buffer circuit 30 is changed to an "L" level, and the content of the corresponding bit of the control signal word CT is changed to "1". The P correction discrimination code in the control signal word CT is forcibly set to "0".

The tri-state buffer circuit 30 can take three different states, namely the two states where the output signal level is respectively "H" (high level) and "L" (low level) and a floating state where the output impedance is substantially infinite, that is, as if the output line were disconnected. Of these states, the switching between the operative state where the output is "H" or "L" and the aforementioned floating state is done according to an enable signal supplied to an enable terminal EN of the tri-state buffer circuit 30. The output from the chip select terminal $CS_3$ of the recording LSI 10 is supplied to the enable terminal EN.

When the tri-state buffer circuit 30 is put into the aforementioned operative state by the output from the chip select terminal $CS_3$, it supplies an "H" or "L" control data signal through the four lines to the terminals $D_0$ to $D_3$ of the recording LSI 10. At this time, the aforementioned signal data should not be present on the data bus, and the chip select signal from the chip select terminal $CS_3$ is provided during the vertical blanking period or horizontal sync signal period in the data format mentioned above. The control data from the tri-state buffer circuit 30 is partly placed in the control signal block CDB shown in Figure 4A or 4B, so that it has to be supplied to the recording LSI 10 before the control signal block CDB is provided.

In the control signal block CDB, the 56-bit heading signal word S, 14-bit content discrimination signal word T, 28-bit address signal word U, 14-bit control signal word CT and 16-bit error detection word CRC are as shown in Figure 2. Of these words, the content of the heading signal word S is preset to, for example, "11001100 ... 1100", and the error detection word RC is determined on the basis of a total of 112 bits of the other words of the block. Thus, while the externally controllable words are the content discrimination signal word T, address signal word U and control signal word CT, a total of 56 bits, the most important is the lower 4 bits in the control signal word CT (bit numbers 11 to 14 in Table 1). Therefore, no problems arise in operation if the 52 bits other than the aforementioned 4 bits of the control signal word CT are all set to "0".

When effecting complex signal processing, such as editing the PCM audio signal or adding special effects thereto, however, predetermined contents have to be written into the content discrimination signal word T, address signal word U, etc., and it is thus necessary to supply these contents to the record LSI 10. To this end, the data terminals $D_0$ to $D_6$ are connected through a tri-state buffer circuit 36 with a latch function to data input/output terminals of a central processing unit (CPU) 37 in a microcomputer, and the output of the chip select terminal $CS_2$ of the record LSI 10 is supplied to the tri-state buffer circuit 36 and to the enable terminal of the CPU 37. The output of the chip select terminal $CS_2$ is supplied during a period during which no data from the RAM 25 is being read out from the recording LSI 10, for example the aforementioned vertical blanking period.

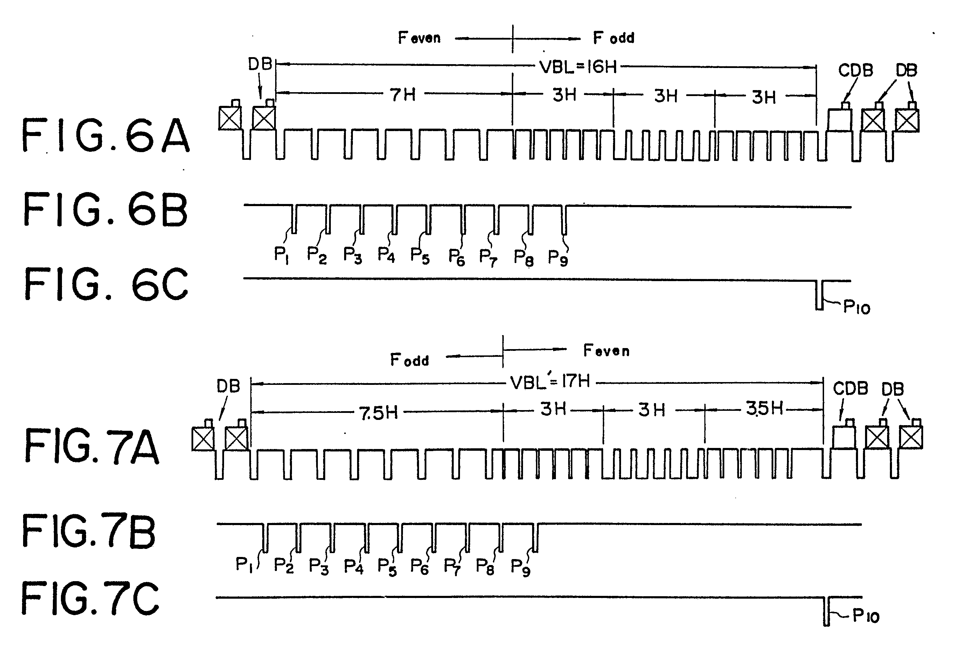

Figures 6 and 7 show time charts around the time of the vertical blanking period. Figures 6A and 7A show the data signal from the output terminal 27, Figures 6B and 6C the output signal from the chip select terminal $CS_2$, and Figures 7B and 7C the output signal from the chip select terminal $CS_3$. Figure 6 shows a vertical blanking period VBL of sixteen horizontal lines after an even field $F_{even}$ and before an odd field $F_{odd}$, and Figure 7 shows the vertical blanking period VBL' after an odd field $F_{odd}$ and before an even field $F_{even}$. During these periods VBL and VBL', the reading of data from the RAM 25 is inhibited.

In Figures 6A, 6B and 6C or 7A, 7B and 7C, in the 1 H period, nine successive pulses are provided from the chip select terminal $CS_2$ with a delay time of, for example 0.5 H with respect to the instant of start of the vertical blanking period VBL or VBL'. Of these nine successive pulses $P_1$, $P_2$, ... $P_9$, the first pulse $P_1$ is used, for example, for the timing matching or stand-by mode of the CPU 37, and at this time the aforementioned control data is not supplied. At the time of appearance of the next pulses $P_2$ and $P_3$, the 14-bit content of the content discrimination signal word T is supplied as 7-bit parallel data from the CPU 37 through the tri-state buffer circuit 36 to the recording LSI 10. At the time of appearance of the pulses $P_4$, $P_5$, $P_6$ and $P_7$, the 28-bit content of the address signal word U is supplied as four 7-bit parallel data. At the time of appearance of the pulses $P_8$ and $P_9$, the 14-bit content of the control signal word CT is supplied as two 7-bit parallel data.

Figure 6C or 7C shows the output of the chip select terminal $CS_3$, namely a pulse $P_{10}$ which is provided before the control data block CDB, for instance in the immediately preceding period of the horizontal sync signal HS. At the time of the appearance of the pulse $P_{10}$, the 4-bit data from the tri-state circuit 30 as mentioned above is supplied to the terminals $D_0$ to $D_3$ of the record LSI 10. In the usual PCM audio signal processing system, it is sufficient to supply only the control data from the tri-state buffer circuit 30, and the supply of the control data from the CPU 37 is not always necessary.

Moreover, the pulses $P_1$ to $P_{10}$ are provided with the timing of reading out data to the recording LSI 10 (data input), and this data input timing may be made to have a fixed phase difference with respect to the aforementioned write pulse (with a cycle period of 2.8 microseconds), for example delayed thereafter by one half the cycle period, that is, 1.4 microseconds. This is equal to the relation between the read timing and write timing with respect to the RAM 25; since no read pulse is provided during the aforementioned blanking period, the pulses $P_1$ to $P_{10}$ may be provided with a timing corresponding to the aforementioned read timing.

The construction of the playback side of the system of Figure 5 will now be described. The playback PCM audio signal from the VTR is supplied through a playback signal input terminal 41 to the sync separator 20, in which the data signal is separated from the sync signal and clock signal components. The data signal component is supplied to a terminal $PD_{in}$ of a playback LSI 40, while the sync signal and clock signal components are supplied to the playback LSI 40 and the dubbing terminal $d$ of the switch 18. The playback LSI 40 effects the operation inverse to the aforementioned interleave (that is, de-interleave) and also the correction of errors on the basis of the PCM audio signal data of the format conforming to the standard television signal mentioned above, thus providing substantially continuous digital data free from a blank portion corresponding to the sync signal, and which is supplied to a digital-to-analog (D/A) converter 42. The D/A converter 42 converts this digital data into the original analog audio signal which is supplied to an output terminal 43.

The playback LSI 40 has its data input/output terminals $D_0$ to $D_7$, and address output terminals $A_0$ to $A_{10}$ connected through a respective data bus and address bus to the RAM 45, and like the recording side various control data can be transmitted through the data bus.

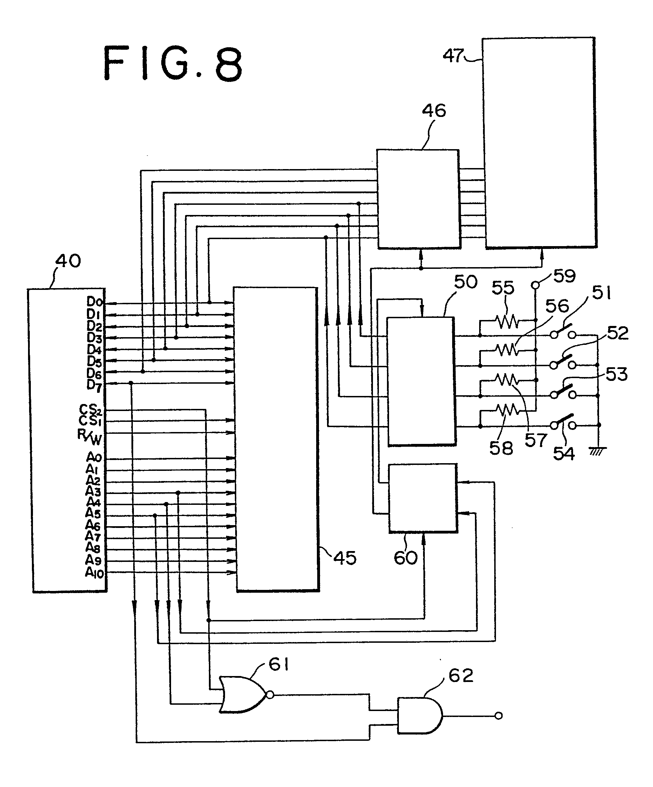

Figure 8 shows a circuit digram of an example of the construction for supplying control data to the data terminals $D_0$ to $D_7$ of the playback LSI 40.

In Figure 8, in addition to the aforementioned data bus and address bus the chip select terminal $CS_1$ and read/write terminal R/W of the playback LSI 40 are connected to respectively corresponding terminals of an RAM 45. Of the data bus mentioned above, 7 lines for the respective terminals $D_0$ to $D_6$ are connected through the latch circuit 46 to a CPU of a microcomputer. Some of these data lines, namely the four lines $D_0$ to $D_3$, are connected to a 4-output tri-state buffer circuit 50, and switches 51 to 54 are respectively connected to four input terminals of the tri-state buffer circuit 50. These switches have the following roles. The switch 51 switches the NTSC and PAL systems; for the PAL system it is turned "on", and for the NTSC system it is turned "off". When the switch 52 is turned "on", a through rate limiting circuit is forcibly rendered operative. When the switch 53 is turned "on", the through rate limiting circuit is rendered operative only in the presence of a muting output. When the switch 54 is "on", the through rate limiting circuit is "on" only when the muting output is present. When three successive errors of the de-interleave occur, the through rate limiting circuit is rendered operative although the muting output does not appear.

The tri-state buffer circuit 50, to which the switches 51 to 54 are connected, has its four input terminals connected through respective pull-up resistors 55 to 58 to a power supply terminal 59, of, for example, +15 V. To the enable terminal of a 2-input 2-output tri-state buffer circuit 60 is supplied the output from the second chip select terminal $CS_2$; as mentioned earlier the pulse from the chip select terminal $CS_2$ is provided during the period during which no actual signal data is transmitted to the data bus, thus rendering the tri-state buffer circuit 60 operative. The outputs from the address terminals $A_3$ and $A_5$ are supplied to the two input terminals of the tri-state buffer circuit 60. The outputs of the tri-state buffer circuit 60 corresponding to these inputs are respective supplied to the latch circuit 46, the clock input terminal of the CPU 47 and the enable terminal of the 4-input 4-output tri-state buffer circuit 50. The output of the address terminal $A_4$ of the playback LSI 40 and the output of the chip select terminal $CS_2$ are supplied through a NOR circuit 61 to an AND circuit 62. The output of the data terminal $D_7$ is supplied to the AND circuit 62. In the timing when the output of the NOR circuit 61 becomes "H" the output of the terminal $D_7$ is either "L" or "H" depending upon whether the detected data at the time of the error detection made by the CRC is correct, the errors in the data currently under processing can thus be checked for from the output of the AND circuit 62.

As has been made apparent in the foregoing, while the reading of data from the RAM 25 by the recording LSI 10 is always made, the writing is not effected during the aforementioned vertical blanking period. During this blanking period, pulses are provided from the chip select terminals $CS_2$ and $CS_3$, as shown in Figures 6B and 6C or 7B and 7C, permitting the reading of control data to the recording LSI 10 through the data bus. The playback LSI 10 can provide entirely the reverse operation to supply the control data through the data bus during the vertical blanking period. Thus, there is no need to provide any exclusive pins for control data.

## Claims

1. A circuit arrangemernt for processing digital data in serial format, the arrangement comprising:

an integrated circuit (10; 40) with a clock terminal, a read-write terminal (R/W), an input terminal ($SD_{in}$; $PD_{in}$) for receiving said digital data, an output terminal ($RD_{out}$; $SD_{out}$) for deriving blocks of digital data (DB, CDB) each preceded by a synchronizing signal (VBL), data terminals ($D_0$ to $D_7$) and address terminals ($A_0$ to $A_{10}$); and

memory means (25; 45) connected to said read-write terminal (R/W), data terminals ($D_0$ to $D_7$) and address terminals $A_0$ to $A_{10}$) of said integrated circuit (10; 40); characterised by:

at least one control data input terminal (31 to 34; 51 to 54) for receiving control data (CDB) to be transmitted together with said digital data (DB) or control data to control functions of said integrated circuit (10; 40); and

a buffer circuit (30; 50) connected between said at least one control data input terminal (31 to 34; 51 to 54) and one or more of said data terminals ($D_0$ to $D_7$) of said integrated circuit (10; 40);

wherein said integrated circuit (10; 40) further includes at least one control terminal ($CS_3$; $CS_1$) and provides said buffer circuit (30; 50) through said control terminal ($CS_3$; $CS_1$) with a control signal so as to make said buffer circuit (30; 50) conductive at times during said synchronizing signal (VBL) when said control data from said at least one control data input terminal (31 to 34; 51 to 54) is to be supplied to said integrated circuit (10; 40).

2. A circuit arrangement according to claim 1, wherein said buffer circuit comprises a first tri-state buffer circuit (30; 50) which can take a high or low signal output state depending upon the signal conditions of said input terminals (31 to 34; 51 to 54).

3. A circuit arrangement according to claim 2 wherein said first tri-state buffer circuit (30) can take a floating output signal state when it receives an input from said at least one control terminal ($CS_3$; $CS_1$).

4. A circuit arrangement according to claim 3 including an oscillator (16) which supplies clock inputs to said integrated circuit (10) and to an analog-to-digital converter (12) which converts input audio data into said digital data.

5. A circuit according to claim 4 including a switch (21) connected to said oscillator (16) to change the frequency of the clock signal to said integrated circuit (10) for NTSC and PAL television signal formats.

6. A circuit according to claim 2 or claim 3 wherein said buffer circuit (30) further comprises a second tri-state buffer circuit (36) connected to certain ($D_0$ to $D_6$) of said data terminals and a further control terminal ($CS_2$) of said integrated circuit (10), and further comprising a microcomputer (37) connected to said second tri-state buffer circuit (36).

7. A circuit according to claim 2 or claim 3 wherein said buffer circuit (50) further comprises a latch circuit (46) connected to said integrated circuit (40), and a microcomputer (47) connected to said latch circuit (46).

## Patentansprüche

1. Schaltungsanordnung zur Verarbeitung von digitalen Daten im Serienformat, mit einer integrierten Schaltung (10; 40), die einen Taktanschluß, eine Lese-Schreib-Anschluß (R/W), einen Eingangsanschluß ($SD_{in}$; $PD_{in}$) für die Aufnahme der genannten digitalen Daten, einen Ausgangsanschluß ($RD_{out}$; $SD_{out}$) zur Ableitung von Blöcken von digitalen Daten (DB, CDB), deren jedem ein Synchronisiersignal (VBL) vorangeht, Datenanschlüsse ($D_0$ bis $D_7$) und Adressenanschlüsse ($A_0$ bis $A_{10}$) aufweist, und mit Speichereinrichtungen (25; 45), die an dem Lese/Schreib-Anschluß (R/W), an den Datenanschlüssen ($D_0$ bis $D_7$) und den Adressenanschlüssen ($A_0$ bis $A_{10}$) der genannten integrierten Schaltung (10; 40) angeschlossen sind, dadurch gekennzeichnet, daß zumindest ein Steuerdateneingangsanschluß (31 bis 34; 51 bis 54) für die Aufnahme von zusammen mit den genannten digitalen Daten (DB) zu übertragenden Steuerdaten (CDB) oder für die Aufnahme von Steuerdaten vorgesehen ist, um Funktionen der genannten integrierten Schaltung (10; 40) zu steuern, und daß eine Pufferschaltung (30; 50) zwischen dem zumindest einen Steuerdateneingangsanschluß (31 bis 34; 51 bis 54) und einem oder mehreren der genannten Datenanschlüsse ($D_0$ bis $D_7$) der genannten integrierten Schaltung (10l 40) angeschlossen ist, wobei die betreffende Schaltung (10; 40) ferner zumindest einen Steueranschluß ($CS_3$; $CS_1$) enthält und an die betreffende Pufferschaltung (30; 50) über den genannten Steueranschluß (CS3; CS1) ein Steuersignal abgibt, derart, daß die betreffende Pufferschaltung (30; 50) zu Zeiten während des Synchronisiersignals (VBL) leitend gemacht ist, wenn die Steuerdaten von dem zumindest einen Steuerdateneingangsanschluß (31 bis 34; 51 bis 54) an die genannte integrierte Schaltung (10; 40) abzugeben sind.

2. Schaltungsanordnung nach Anspruch 1, wobei die Pufferschaltung eine erste Tri-State-Pufferschaltung (30; 50) enthält, die in Abhängigkeit von den Signalzuständen der betreffenden Eingangsanschlüsse (31 bis 34; 51 bis 54) einen Ausgangszustand entsprechend einem hohen oder einem niedrigen Signal-pegel annehmen kann.

3. Schaltungsanordnung nach Anspruch 2, wobei die erste Tri-State-Pufferschaltung (30) einen schwimmenden Ausgangssignalzustand annehmen kann, wenn sie ein Eingangssignal von dem zumindest einen Steueranschluß ($CS_3$, $CS_1$) aufnimmt.

4. Schaltungsanordnung nach Anspruch 3, mit einem Oszillator (16), der die Takteingänge der genannten integrierten Schaltung (10) und einen Analog-Digital-Wandler (12) speist, welcher Eingangs-Audiodaten in die genannten digitalen Daten umsetzt.

5. Schaltungsanordnung nach Anspruch 4, mit einem Schalter (21), der an dem Oszillator (16) angeschlossen ist, um die Frequenz des Taktsignals für die genannte integrierte Schaltung (10) bezüglich der NTSC-und PAL-Fernsehsignalformate zu ändern.

6. Schaltungsanordnung nach Anspruch 2 oder 3, wobei die Pufferschaltung (30) ferner eine zweite Tri-State-Pufferschaltung (36) enthält, die an gewissen Anschlüssen ($D_0$ bis $D_6$) der genannten Datenanschlüsse und an einem weiteren Steueranschluß ($CS_2$) der genannten integrierten Schaltung (10) angeschlossen ist, und daß ferner ein Mikrocomputer (37) vorgesehen ist, wobei der mit der genannten zweiten Tri-State-Pufferschaltung (36) verbunden ist.

7. Schaltungsanordnung nach Anspruch 2 oder 3, wobei die genannte Pufferschaltung (50) ferner eine mit der genannten integrierten Schaltung (40) verbundene Signalspeicherschaltung (Latch-Schaltung) (46) enthält, mit der ein Mikrocomputer (47) verbunden ist.

## Revendications

1. Montage de circuit pour traiter des données numériques dans un format en série, le montage comprenant:

un circuit intégré (10; 40) comportant une borne d'horloge, une borne de lecture-écriture (R/W), une borne d'entrée ($SD_{in}$; $PD_{in}$) pour recevoir lesdits données numériques, une borne de sortie ($RD_{out}$; $SD_{out}$) pour dériver des blocs de données numériques (DB, CDB) précédes chacun d'un signal de synchronisation (VBL), des bornes de données ($D_0$ à $D_7$) et des bornes d'adress ($A_0$ à $A_{10}$); et

des mémoires (25; 45) connectées à la borne de lecture-écriture (R/W), aux bornes de données ($D_0$ à $D_7$) et aux bornes d'adresse ($A_0$ à $A_{10}$) du circuit intégré (10; 40); caractérisé en ce qu'il comprend:

au moins une borne d'entrée de données de commande (31 à 34; 51 à 54) pour recevoir des données de commande (CDB) à transmettre avec lesdites données numériques (DB) ou des données de commande pour commander des fonctions du circuit intégré (10; 40); et

un circuit tampon (30; 50) connecté entre au moins ladite borne d'entrée de données de commande (31 à 34; 51 à 54) et une ou plusieurs bornes de données (D$_0$ à D$_7$) du circuit intégré (10; 40);

ledit circuit intégré (10; 40) comprenant en outre au moins une borne de commande (CS$_3$; CS$_1$) et envoyant au circuit tampon (30; 50) un signal de commande par l'intermédiaire de la borne de commande (CS$_3$, CS$_1$) de manière à rendre le circuit tampon (30; 50) conducteur en présence du signal de synchronisation, quand les données de commande provenant d'au moins une borne d'entrée de données de commande (31 à 34; 51 à 54) doivent être fournies au circuit intégré (10; 40).

2. Montage de circuit selon la revendication 1, caractérisé en ce que le circuit tampon comprend un premier circuit tampon à trois états (30; 50) qui peut prendre un état de signal de sortie haut ou bas selon l'état des signaux aux bornes d'entrée (31 à 34; 51 à 54).

3. Montage de circuit selon la revendication 2, caractérisé en ce que ledit premier circuit tampon à trois états (30; 50) peut prendre un état de signal de sortie flottant quand il reçoit un signal d'entrée d'au moins une borne de commande (CS$_3$; CS$_1$).

4. Montage de circuit selon la revendication 3, caractérisé en ce qu'il comprend un oscillateur (16) qui envoie des signaux d'entrée d'horloge au circuit intégré (10) et à un convertisseur analogique-numérique (12) qui convertit les données d'audiofréquence d'entrée pour obtenir lesdites données numériques.

5. Montage de circuit selon la revendication 4, caractérisé en ce qu'il comprend un commutateur (21) connecté à l'oscillateur (16) pour faire varier la fréquence du signal d'horloge envoyé au circuit intégré (10) pour les formats de signaux de télévision de systèmes "NTSC" et "PAL".

6. Montage de circuit selon l'une quelconque des revendications 2 et 3, caractérisé en ce que le circuit tampon (30) comprend en outre un second circuit tampon à trois états (36) connecté à certaines (D$_0$ à D$_6$) des bornes de données et à une autre borne de commande (CS$_2$) du circuit intégré (10), et en ce qu'il comprend en outre un microordinateur (37) connecté au second circuit tampon à trois états (36).

7. Montage de circuit selon l'une quelconque des revendications 2 et 3, caractérisé en ce que le circuit tampon (50) comprend en outre un circuit de verrouillage (46) connecté au circuit intégré (40), et un microordinateur (47) connecté au circuit de verrouillage (46).

# FIG.1

# FIG.2

FIG.3

FIG.4A

FIG.4B

2

FIG. 5

FIG. 6A

F even ⟶ F odd

DB
VBL=16H
CDB  DB

7H  3H  3H  3H

FIG. 6B

P₁ P₂ P₃ P₄ P₅ P₆ P₇ P₈ P₉

FIG. 6C

P₁₀

FIG. 7A

F odd ⟵ ⟶ F even

DB
VBL'=17H
CDB  DB

7.5H  3H  3H  3.5H

FIG. 7B

P₁ P₂ P₃ P₄ P₅ P₆ P₇ P₈ P₉

FIG. 7C

P₁₀

0 044 713

4

# FIG.8